# EUROPEAN PATENT SPECIFICATION

(11) **EP 2 540 859 B1**
(45) Date of publication and mention of the grant of the patent: **20.12.2017**
(21) Application number: 11744413.3
(22) Date of filing: 16.02.2011
(51) Int. Cl.: C23C 14/30, H01J 37/06, H01J 37/065, H01J 37/10, H01J 37/147, H01J 37/304, H01J 37/305

(54) **ELECTRON BEAM VACUUM PROCESSING DEVICE**
ELEKTRONENSTRAHL-VAKUUMBEARBEITUNGSVORRICHTUNG
DISPOSITIF DE TRAITEMENT À FAISCEAU ÉLECTRONIQUE SOUS VIDE

(30) Priority: 22.02.2010 JP 2010035669
(43) Date of publication of application: 02.01.2013
(73) Proprietor: ULVAC, Inc., Chigasaki-shi, Kanagawa 253-8543 (JP)
(72) Inventor: IIJIMA, Eiichi, Chigasaki-shi Kanagawa 253-8543 (JP); IKEDA, Hiroto, Chigasaki-shi Kanagawa 253-8543 (JP); ISO, Yoshiki, Chigasaki-shi Kanagawa 253-8543 (JP)
(74) Representative: Markfort, Iris-Anne Lucie
(86) International application number: PCT/JP2011/000846
(87) International publication number: WO 2011/102122

(56) References cited:
- DE-A1- 1 539 035
- JP-A- 2 125 868
- JP-A- 7 258 832
- JP-A- H02 125 868
- JP-A- H03 270 214
- JP-A- 2006 045 581
- JP-A- 2009 275 244

## Description

### Technical Field

The present invention relates to a vacuum processing apparatus using an electron gun.

### Background Art

An electron beam uses electrons as an energy source and is capable of easily oscillating, deflecting, and achieving a high density. Further, since a target to be heated is less contaminated, the electron beam is widely used as a heat source of a vacuum vapor deposition apparatus, a surface treatment apparatus, a vacuum heat treatment apparatus, a vacuum melting furnace, a vacuum refining furnace, or the like (see, for example, Non-Patent Document 1).

An electron beam vapor deposition apparatus using an electron gun, for example, a pierce-type electron gun, includes a pierce-type electron gun as a beam generation source and a vacuum vapor deposition chamber in which an evaporation source and a member to be subjected to vapor deposition are set (see, for example, Patent Document 1). In the electron beam vapor deposition apparatus, an evaporation material housed in the evaporation source is heated by irradiation with an electron beam emitted from the electron gun and is vapor-deposited on the member to be subjected to vapor deposition, to thereby form a vapor-deposited film.

Patent Document 1: Japanese Patent Application Laid-open No. 2004-315971 (paragraphs [0018], [0019], and Figures)

Non-Patent Document 1: "Shinkuu Handbook", pp. 141, Chapters 4.5.1 Heating by electron beam and 4.5.2 metal melting by electron beam, November 30, 1992, published by Ohmsha, edited by Japan Vacuum Enginering Co, Ltd.

Further prio art solutions are also known from documents JP H02 125868 A and DE 1 539 035 A1, wherein JP 125868 A refers to a vacuum processing apparatus (in particular an electron-beam vapor deposition device) according to the preamble of claim 1.

DE 1 539 035 A discloses (see figures 1 and 2 there) an electron beam melting or evaporation apparatus comprising an electron beam focusing mechanism, including two focusing coils 5,6 provided in a processing chamber, and a plurality of thermocouples 10 arranged at a pass point of the electron beam corresponding to the plurality of focusing coils, and an automatic control unit that controls the values of current supplied to the focusing coils based on the measurement results by the thermocouples.

### Disclosure of the Invention

### Problems to be solved by the Invention

In the electron beam vapor deposition apparatus, a beam of high-density electrons emitted from the pierce-type electron gun tends to be diffused by a space-charge effect during passage through a high vacuum. As a result, a sufficient power density cannot be ensured in the evaporation source serving as an electron beam irradiation point, which causes a problem that an evaporation rate of the evaporation material may be significantly reduced. In particular, in the may be significantly reduced. In particular, in the case where a metal wiring film or the like is formed on a large-size substrate constituting a flat panel display, the film is formed in a large area under a high vacuum atmosphere. Further, in terms of an apparatus design, a distance between the evaporation source and the pierce-type electron gun is required to be elongated. Accordingly, the electron beam is diffused by the time it reaches the evaporation source from the pierce-type electron gun, and the evaporation rate is reduced. Thus, it has been difficult to perform film formation in a large area. In addition, since a focused state of the electron beam is varied due to an output (current value) of the beam, a pressure of the vacuum vapor deposition chamber, an impedance of the atmosphere, and the like, there arise a problem that the evaporation rate fluctuates and a stable film formation cannot be performed.

To solve those problems, it is also possible to increase an acceleration voltage of electrons to suppress the diffusion of the beam. However, new problems may be caused accordingly, such as intensified insulation of a high-voltage application unit of the electron gun, intensified insulation of high-voltage wiring from a power source of the electron gun to the electron gun, intensified insulation of a high-voltage

In view of the circumstances as described above, it is an object of the present invention to provide a vacuum processing apparatus capable of suppressing the diffusion of an electron beam even in a high vacuum region and performing stable processing at an optimal density of the electron beam.

### Means for solving the Problem

According to the present invention, there is provided a vacuum processing apparatus with the features of claim 1. Preferred aspects are set out in the dependent claims.

### Brief Description of Drawings

[Fig. 1] A partial perspective view schematically showing an in-line electron beam vapor deposition apparatus according to an embodiment of the present invention.
[Fig. 2] A schematic cross-sectional view cut along A-A' of Fig. 1.
[Fig. 3] A schematic cross-sectional view of a pierce-type electron gun including focusing coils at two stages.
[Fig. 4] A graph showing a relationship between a pressure of a vacuum vapor deposition chamber and a deposition rate.
[Fig. 5] A graph showing a relationship between a pressure of a process chamber and a diameter of an electron beam.
[Fig. 6] A graph showing a beam expansion state when the effect of a neutralizing action is not obtained at all.
[Figs. 7] Diagrams each showing a state of an electron beam emitted from an electron gun.
[Fig. 8] A graph showing a magnetic flux density distribution when a current of a predetermined value is caused to flow in each of the first focusing coil provided in the electron gun and the second focusing coil provided in the electron beam focusing mechanism in the structure shown in Fig. 2.
[Fig. 9] A graph showing a state of the electron beam when a current of a predetermined value is caused to flow in the first focusing coil provided in the electron gun and a value of a current caused to flow in the second focusing coil provided in the electron beam focusing mechanism is changed in the structure shown in Fig. 2.
[Fig. 10] A graph showing a relationship between the value of a current supplied to the second focusing coil provided in the electron beam focusing mechanism and a temperature measured by a thermocouple.
[Fig. 11] A graph showing a state of the electron beam when a current of a predetermined value is caused to flow in each of the first focusing coil provided in the electron gun and the second focusing coil provided in the electron beam focusing mechanism, and a value of a current caused to flow in a third focusing coil provided in the electron beam focusing mechanism is changed in the structure shown in Fig. 2.
[Fig. 12] A graph showing a relationship between the value of a current supplied to the third focusing coil provided in the electron beam focusing mechanism and a temperature measured by the thermocouple.
[Fig. 13] A diagram showing a state of the electron beam when a predetermined current is caused to flow in each of the focusing coil of the electron gun and the second focusing coil and the third focusing coil provided in the electron beam focusing mechanism.
[Fig. 14] A graph showing a relationship between an input power and a static rate in the vapor deposition apparatus according to the present invention.
[Fig. 15] A graph showing a relationship between a deposition rate and a deposition time in the vapor deposition apparatus according to the present invention.
[Figs. 16] Schematic cross-sectional diagrams showing vapor deposition apparatuses of the embodiment and Modified examples of the present invention.

### Best Mode for Carrying Out the Invention

According to the present invention, there is provided a vacuum processing apparatus including a processing chamber, an electron gun, and an electron beam focusing mechanism. In the processing chamber, a target to be processed is set. The processing chamber is capable of maintaining a vacuum atmosphere. The electron gun is provided adjacently to the processing chamber and emits an electron beam to heat the target to be processed. The electron beam focusing mechanism is provided in the processing chamber and focuses the electron beam emitted from the electron gun.

According to this vacuum processing apparatus, since the electron beam emitted from the electron gun is focused by the electron beam focusing mechanism provided in the processing chamber and then applied to the target to be processed, the diffusion of the electron beam due to passage through the processing chamber of the vacuum atmosphere is suppressed. Accordingly, an optimal density of the electron beam can be ensured and stable processing with respect to the target to be processed can be ensured.

The electron beam focusing mechanism includes focusing coils. With this structure, the electron beam can be focused by the focusing coils.

The electron beam focusing mechanism further includes a thermocouple and a control unit. The thermocouple measures a temperature at a pass point of the electron beam. The control unit controls a pressure in the electron beam focusing mechanism based on a measurement result by the thermocouple.

According to the structure described above, the pressure in the electron beam focusing mechanism is controlled based on the temperature at the pass point of the electron beam, the temperature being measured by the thermocouple. Thus, since the expansion and contraction of the electron beam is changed in accordance with the pressure, a desired shape of the electron beam can be obtained by the control on the pressure.

The electron gun may include a first oscillation coil, and the electron beam focusing mechanism may include a second oscillation coil. The electron beam is deflected by the first oscillation coil and the second oscillation coil and applied to the target to be processed.

With this, since the electron beam is deflected using the first oscillation coil and the second oscillation coil, a deflection means for deflecting the electron beam is not necessarily provided other than the electron gun and the electron beam focusing mechanism. Therefore, the excellent controllability of the electron beam to be applied to an evaporation material is obtained.

The target to be processed may be an evaporation material. In this case, the electron gun constitutes a heat source to heat the evaporation material by the electron beam. With this, it is possible to provide a vapor deposition apparatus capable of ensuring a sufficient power density in the evaporation material and preventing an evaporation rate from being reduced.

The evaporation material may be metal or a metal oxide.

According to the vacuum processing apparatus described above, a diffused electron beam is focused by the electron beam focusing mechanism even in the film formation of a metal film in which the electron beam is significantly diffused under high vacuum. Therefore, it is possible to ensure a sufficient power density in the evaporation source and prevent an evaporation rate from being reduced.

Hereinafter, an embodiment of the present invention will be described with reference to the drawings.

### [Structure of vapor deposition apparatus]

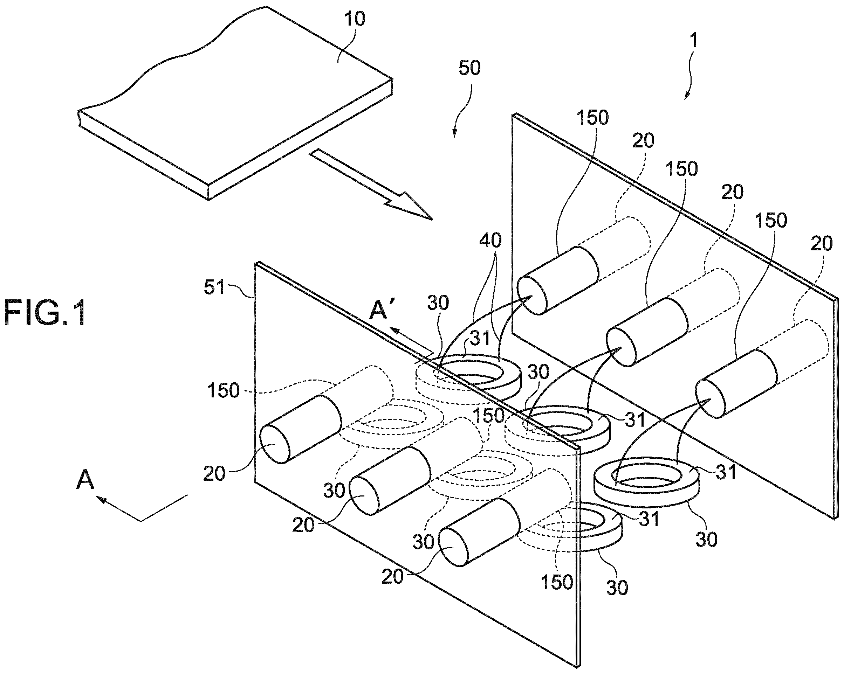

Fig. 1 is a partial perspective view schematically showing an in-line electron beam vapor deposition apparatus 1 as a vacuum processing apparatus according to an embodiment of the present invention. Fig. 1 shows a position relationship between a transfer direction of a glass substrate serving as a member to be subjected to processing in a vacuum vapor deposition chamber, an electron gun 20 serving as an electron beam generation apparatus, and an electron beam focusing mechanism 150.

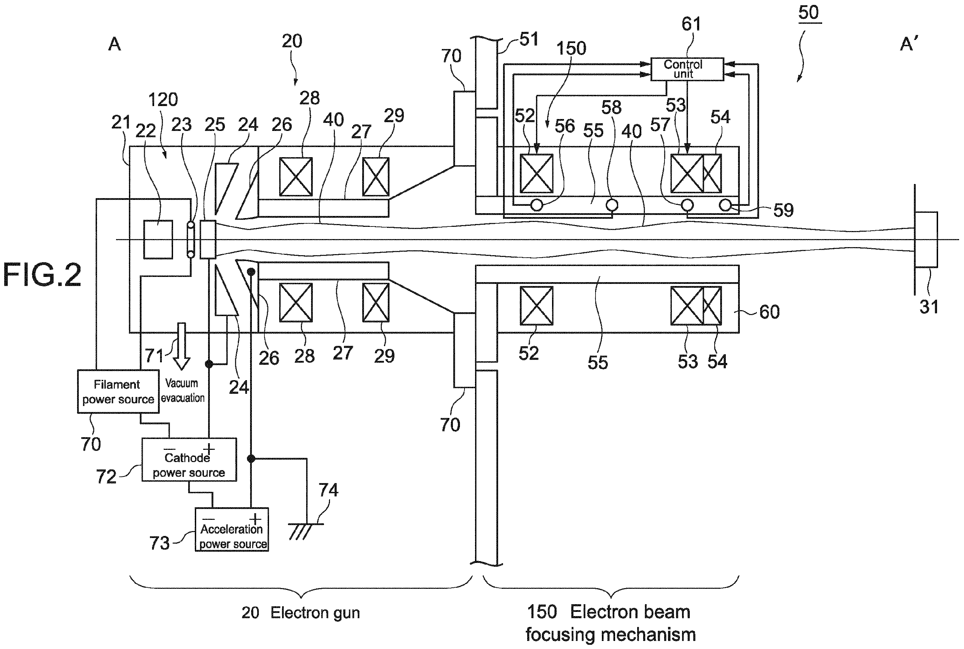

Fig. 2 is a schematic cross-sectional view cut along A-A' of Fig. 1. An electron beam emitted from the pierce-type electron gun is deflected by a deflection coil (not shown) serving as a deflection means and then applied to an evaporation source in a vacuum vapor deposition chamber. In Fig. 2, however, for easy understanding of the drawings, the electron beam is not deflected and linearly applied to an evaporation material (target) 31.

As shown in Fig. 1, the in-line electron beam vapor deposition apparatus 1 includes a vacuum vapor deposition chamber 50 serving as a processing chamber to/in which a glass substrate 10 is transferred and housed, the electron guns 20 arranged adjacently to the vacuum vapor deposition chamber 50, and the electron beam focusing mechanisms 150 provided in the vacuum vapor deposition chamber 50. In the in-line electron beam vapor deposition apparatus 1, the evaporation material 31 is heated by the electron beam 40 emitted from the electron gun 20, evaporated, and formed as a vapor-deposited film on the glass substrate 10.

The vacuum vapor deposition chamber 50 includes a vacuum chamber 51 whose cross section in a direction perpendicular to the transfer direction of the glass substrate 10 has a rectangular shape, and rotary ring hearths 30 (evaporation sources) in which the evaporation materials 31 arranged on the bottom surface of the vacuum chamber 51 are housed. The glass substrate 10 is designed to be capable of being transferred in a horizontal direction on an upper side of the vacuum chamber 51. The vacuum vapor deposition chamber 50 is designed to be capable of maintaining a vacuum.

A plurality of electron guns 20 are fixedly provided by attachment flanges 70 on the outer wall surfaces on both sides of the vacuum chamber 51 when viewed from the transfer direction of the glass substrate 10. The inside of each of the electron guns 20 communicates with that of the vacuum vapor deposition chamber 50.

As shown in Fig. 2, the electron guns 20 each include a casing 21, a cathode chamber 120 provided in the casing 21, and an vacuum evacuation system to evacuate the cathode chamber 120 to a degree of vacuum as indicated by an arrow 71. The electron gun 20 includes an ion collector 22, a filament 23, a cathode 25, a wehnelt 24, an anode 26, a flow register 27, a first focusing coil 28, and a first oscillation coil 29.

The filament 23 generates heat due to Joule heat by an alternating current passing therethrough and emits thermal electrons.

The cathode 25 is heated by receiving electrons that are generated and accelerated in the filament 23 by an application of a positive voltage to the filament 23, and emits thermal electrons.

The wehnelt 24, which is also referred to as a focus electrode, has the same potential as the cathode 25 and forms an electric field between the wehnelt 24 and the anode 26 in which electrons are directed toward the center of the anode 26, to thereby efficiently generate an electron beam.

The anode 26 is at a positive potential with respect to the cathode 25 and is for accelerating the thermal electrons generated in the cathode 25. The anode 26 is at a ground potential 74, and a negative voltage is applied to the cathode 25. The electron beam passes through a hole located at the center of the anode 26.

Ions generated by a collision of the electron beam with a residual gas in the atmosphere and the like are accelerated by the voltages of the anode 26 and the cathode 25 and thus form a hole by sputtering the cathode 25. An ion collector 22 is provided such that, when a hole that passes through the cathode 25 is formed due to a prolonged use, the casing 21 is not damaged due to the reception of an ion beam.

The flow register 27 is for reducing conductance and keeping a pressure of the cathode chamber 20 low.

The first focusing coil 28 is for focusing the beam that has passed through the anode 26 to the evaporation material 31 housed in the ring hearth 30 by a generated magnetic field. The focusing coil 28 is a coil of, for example, 520 turns, and is provided at a position distant from the surface of the cathode 25 by 100 mm, for example.

The first oscillation coil 29 is for scanning or sweeping the electron beam on the evaporation material 31 housed in the ring hearth 30.

The filament 23 is connected to a filament power source 70, and the filament 23 and the cathode 25 are connected to a cathode power source 72. When the filament power source 70 applies power to the filament 23, the filament 23 is heated to generate thermal electrons. Further, the cathode power source 72 applies a voltage between the filament 23 and the cathode 25. By the collision of the thermal electrons and the radiant heat from the filament 23, the cathode 25 is heated, thus emitting thermal electrons from the surface of the cathode 25. The cathode 25, the wehnelt 24, and the anode 26 are connected to an acceleration power source 73. A voltage is applied between the cathode 25 and the anode 26 by the acceleration power source 73, and the thermal electrons emitted from the surface of the cathode 25 are accelerated toward the anode 26, thus forming an electron beam. It should be noted that due to a potential gradient between the wehnelt 24 and the anode 26, the thermal electrons emitted from the surface of the cathode 25 are focused toward the anode 26.

A plurality of electron beam focusing mechanisms 150 are provided so as to correspond to the respective electron guns 20 on the inner wall surfaces on both sides of the vacuum chamber 51 when viewed from the transfer direction of the glass substrate 10.

The electron beam focusing mechanisms 150 each include a casing 60 having a cylindrical outer shape, a beam transport pipe 55 provided in the casing 60, a second focusing coil 52 provided in the casing 60 and at the circumference of the beam transport pipe 55 (first focusing coil of electron beam focusing mechanism), a third focusing coil 53 (second focusing coil of electron beam focusing mechanism), a second oscillation coil 54, and thermocouples 56 to 59 provided to the beam transport pipe 55.

The beam transport pipe 55 has a cylindrical structure made of, for example, Cu and is capable of being cooled by a cooling means (not shown).

Each of the second focusing coil 52 and the third focusing coil 53 is of, for example, 500 turns and has a structure in which a current of up to 3A is caused to flow. In this embodiment, the second focusing coil 52 and the third focusing coil 53 are provided at positions distant from the surface of the cathode 25 by 300 mm and 500 mm, respectively.

The first focusing coil 28, the second focusing coil 52, and the third focusing coil 53 are provided so as to correspond to a diffused state of the electron beam 40, and the electron beam in the diffused state is focused by the focusing coils. Assuming that a traveling direction of the electron beam is a y axis and an expansion direction of the electron beam is a z axis, the focusing coils are provided at positions at which the electron beam has a small value of dz/dy and has a diameter of a predetermined value or smaller.

The second oscillation coil 54 can have the same structure as the first oscillation coil 29. For example, as viewed from the electron gun 20, an x-axis oscillation frequency is 500 Hz, a y-axis oscillation frequency is 222 Hz, and a position movement frequency is 50 Hz to 100 Hz.

The plurality of thermocouples 56 to 59 are provided along a beam path of the electron beam 40. Each of the thermocouples 56 to 59 is a sensor for detecting a temperature of the electron beam 40 at its pass point. The thermocouple 56 is arranged to correspond to the second focusing coil 52, and the thermocouple 57 is arranged to correspond to the third focusing coil 53. The thermocouple 58 is arranged to correspond to a position between the second focusing coil 52 and the third focusing coil 53, and the thermocouple 59 is arranged in the vicinity of an end portion of the electron beam focusing mechanism 150 on the side where the electron beam is output.

In this embodiment, the four thermocouples are provided. However, it suffices to arrange thermocouples at positions at least corresponding to the focusing coils. For example, in the case where two focusing coils are provided, two thermocouples only have to be provided. Further, without being limited to the number of focusing coils, a larger number of thermocouples than the number of focusing coils may be provided along the beam path of the electron beam 40. As the number of thermocouples becomes larger, a more accurate shape of the electron beam can be grasped.

Measurement results by the thermocouples 56 to 59 are input to the control unit 61. According to an example not forming part of the claimed invention (analogous to DE 15 39 035 A as cited above), based on the results, a current to be supplied to the first focusing coil 28, the second focusing coil 52, the and third focusing coil 53, or to the second focusing coil 52 and the third focusing coil 53 is set by the control unit 61. The control unit 61 is provided outside the vacuum chamber 51.

In this example, the current to be supplied to the focusing coils is set based on the results of the temperature measurement by the thermocouples, and the focused state of the electron beam 40 is controlled so that a sufficient power density can be ensured at an irradiation point of the electron beam 40 in the evaporation material 31. According to the invention, based on the results of the temperature measurement by the thermocouples 56 to 59, the pressure in the beam transport pipe 55 is adjusted and set by a control unit (not shown). In other words, since how the electron beam is expanded and contracted is varied in accordance with the degree of vacuum, the focused state of the electron beam 40 can be controlled by the adjustment of the degree of vacuum. Specifically, it is conceived to provide an vacuum evacuation system between the second focusing coil 52 and the third focusing coil 53 and also provide a mechanism for supplying an inert gas such as Ar for the purpose of pressure adjustment, to thereby adjust, based on the results of the temperature measurement by the thermocouples, the degree of vacuum by using the vacuum evacuation system and the inert gas supply mechanism. Alternatively, the vacuum evacuation systems may be provided between the first focusing coil 28 and the second focusing coil 52 or both between the first focusing coil 28 and the second focusing coil 52 and between the second focusing coil 52 and the third focusing coil 53.

In this embodiment, by providing the electron beam focusing mechanism 150 in the vacuum vapor deposition chamber 50, the electron beam 40 emitted from the cathode chamber 120 is applied to the evaporation material 31 after passing through the electron beam focusing mechanism 150. Thus, since the diffused electron beam 40 in the vacuum vapor deposition chamber 50 at high vacuum is focused by the electron beam focusing mechanism 150, a sufficient power density can be ensured in the evaporation material 31 serving as an irradiation point of the electron beam 40, and a reduction in evaporation rate due to the diffusion can be prevented. Further, in the case where a metal film made of Al is formed in order to form wiring made of, for example, Al on a large-size substrate constituting a flat panel display, since the film is formed in a large area, it is necessary to increase a distance between the evaporation source and the pierce-type electron gun in terms of design. However, also in such a case, the evaporation rate is prevented from being reduced by providing the electron beam focusing mechanism 150, and therefore the vapor deposition in the large area can be realized.

Here, in the deposition of an oxide, a significant problem in diffusion of the electron beam does not appear because a process gas is introduced, but in the deposition of a metal film, the significant problem in diffusion of the electron beam appears. Therefore, the vapor deposition apparatus 1 including the electron beam focusing mechanism 150 as in this embodiment is especially effective in the deposition of a metal film.

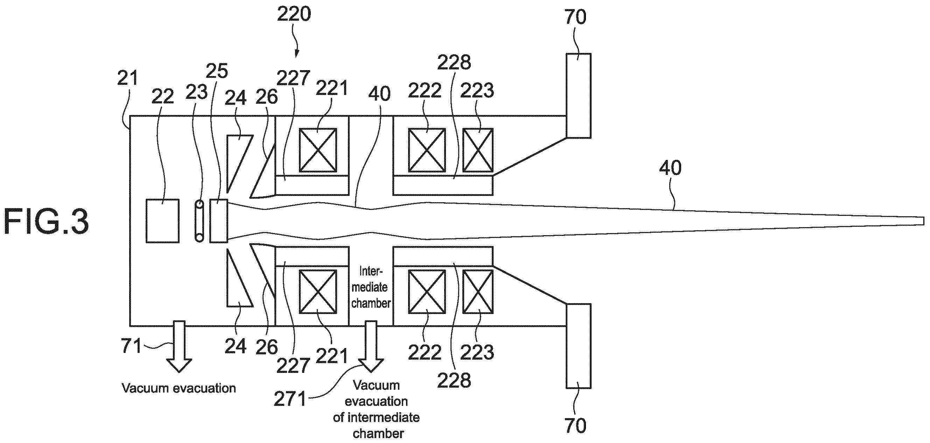

In the embodiment described above, the electron gun 20 having the structure in which one focusing coil is provided has been described, but as shown in Fig. 3, an electron gun 220 provided with two focusing coils may be used. In Fig. 3, the same structure as in the embodiment described above will be denoted by the same reference numerals and a description thereof will be omitted. Further, in Fig. 3, the illustration of the vacuum vapor deposition chamber 50, the electron beam focusing mechanism 150, and the like is omitted.

The pierce-type electron gun 220 in Fig. 3 further includes a first flow register 227, a second flow register 228, focusing coils 221 and 222, an oscillation coil 223, and an evacuation system for evacuating an intermediate chamber to a vacuum degree as indicated by an arrow 271. In Fig. 3, the pierce-type electron gun 220 has a two-stage evacuation system. This is because a differential pressure with respect to the vacuum vapor deposition chamber is ensured. Generally, an indirectly-heated cathode made of tungsten is used for an electron emission source of the pierce-type electron gun. An emission amount of thermal electrons from the cathode surface per unit area is determined based on temperature, as shown in the Richardson-Dushman equation. To obtain a large beam current value, a cathode with a large diameter is required, and therefore a diameter of a hole of the anode and a diameter of a hole of the flow register become larger. For that reasons, conductance is increased and a two-stage vacuum evacuation system is required to ensure a differential pressure with respect to the vacuum vapor deposition chamber.

Further, although the second oscillation coil 54 is provided to the electron beam focusing mechanism 150 in the embodiment described above, the second oscillation coil 54 may be omitted depending on a position relationship among the electron gun 20, the electron beam focusing mechanism 150, and a beam irradiation point. Further, the second oscillation coil 54 may be arranged between the focusing coil 52 and the focusing coil 53.

In the embodiment described above, the focusing coils of the electron beam focusing mechanism 150 are provided at two stages, but the present invention is not limited thereto. The focusing coil may be provided at one stage or three stages or more based on a transport distance of the electron beam, a power density of the electron beam 40, and the atmosphere of the vacuum vapor deposition chamber 50.

As the vapor deposition material 31, metal such as Al, Cu, and Mo or a metal oxide such as MgO are applicable. In particular, as described above, since the electron beam is transported under high vacuum in the deposition of a metal film, the significant problem in the diffusion of the electron beam appears. Therefore, when a metal film made of Al, Cu, or Mo is vapor-deposited to form an electrode on a large-area substrate, it is especially effective to use the electron beam focusing mechanism 150 as shown in the vapor deposition apparatus 1 of this embodiment.

### [Vapor deposition apparatus according to Comparative example]

Here, as Comparative example, a conventional vapor deposition apparatus that does not include the electron beam focusing mechanism 150 will be described.

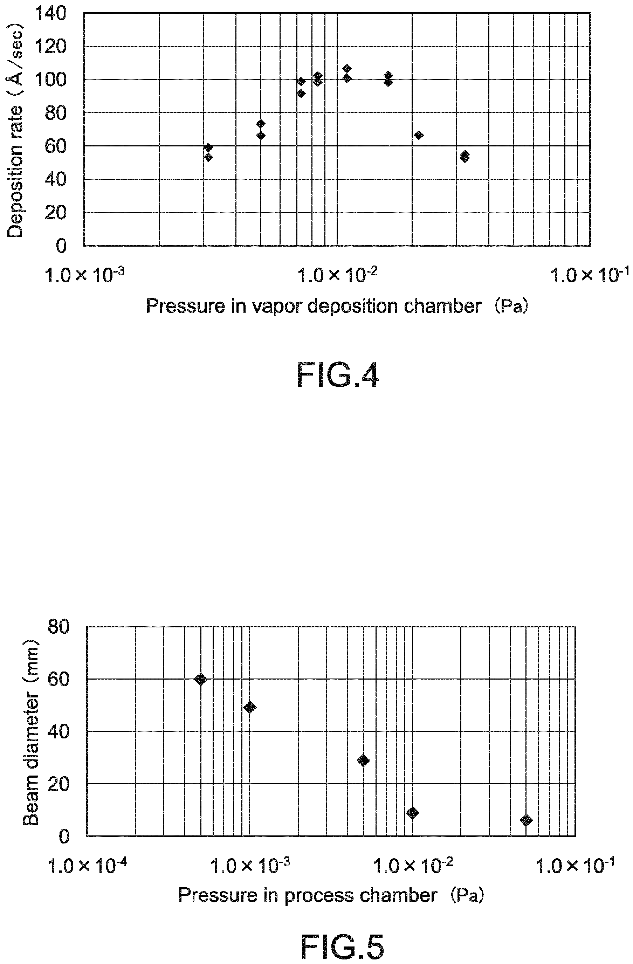

Fig. 4 is a graph showing a relationship between a pressure of a vacuum vapor deposition chamber and a deposition rate of a magnesium oxide in the case where an input power of an electron gun in the conventional vapor deposition apparatus is set to 12.8 kW. Fig. 5 is a graph showing a relationship between a pressure of a process chamber and a diameter of an electron beam when a pierce-type electron gun of an acceleration voltage of 30 kV is used to apply an electron beam of a beam current of 400 mA to a surface of a target made of W, which is placed at a distance of 750 mm from the cathode surface.

As shown in Fig. 4, in the region at a pressure of about 1.0×10⁻² Pa, the electrons emitted from the pierce-type electron gun collide with a residual gas of the vacuum vapor deposition chamber, positive ions generated by the collision neutralize the electron beam, the repellence of negative charges of the electrons is neutralized, and the electron beam keeps the focused state. At a pressure of 3×10⁻³ Pa or lower, a residual gas amount of the vacuum vapor deposition chamber is small, the electrons are diffused by the repellence of negative charges, and thus the power density is lowered and the deposition rate is lowered. On the other hand, at a pressure of 3×10⁻² Pa or higher, the residual gas amount of the vacuum vapor deposition chamber is large. Therefore, the loss caused by the collision of the electrons with the residual gas reduces an electronic current that reaches the evaporation source, and thus a deposition rate is lowered.

As shown in Fig. 5, when a process pressure is lower than 1.0×10⁻² Pa, it can be confirmed that the effect of a neutralizing action of the residual gas with respect to the repellence between negative charges is reduced and the electron beam is diffused.

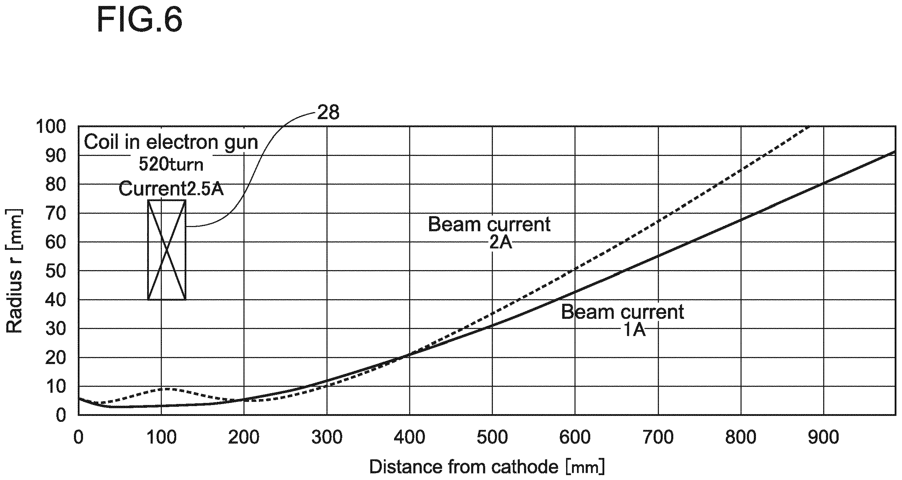

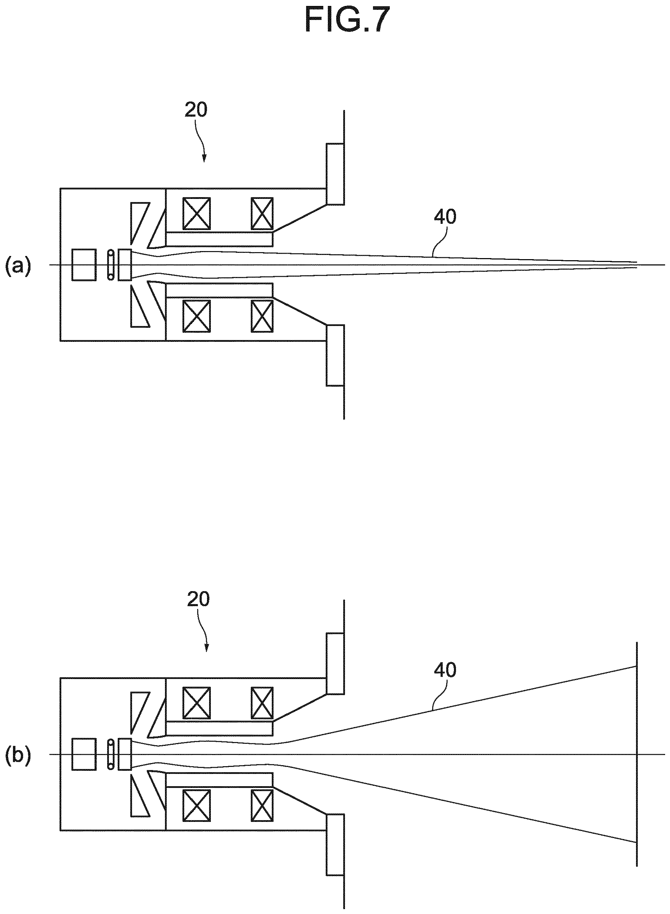

Fig. 6 shows results obtained by simulating a beam expansion state in the case where the effect of the neutralizing action is not obtained at all with the acceleration voltage being set to 30 kW and the beam current being set to 1A and 2A. When the beam current is 1 A, a beam diameter is about 120 mm at a distance of 750 mm from the cathode surface. Based on those results, with use of the electron gun of an acceleration voltage of 30 kV, the electrons emitted from the electron gun are applied to a target in the focused state as shown in Fig. 7(a) in the region where the process pressure is at about 5×10⁻³ Pa to 5×10⁻² Pa. In the region where the pressure is lower than 1×10⁻³ Pa, the electrons are diffused as shown in Fig. 7(b), the power density is reduced, and the evaporation rate is largely reduced.

As described above, in the conventional vapor deposition apparatus, the focused state of the electron beam is changed due to the pressure of the vacuum vapor deposition chamber, the current value (density of electrons) of the electron beam, an atmospheric impedance (type of residual gas), and the like, and the deposition rate largely fluctuates. Therefore, stable deposition is difficultly performed.

### [Evaluation of vapor deposition apparatus in this embodiment]

Next, the vapor deposition apparatus 1 including the electron beam focusing mechanism 150 in the embodiment of the present invention described above will be described.

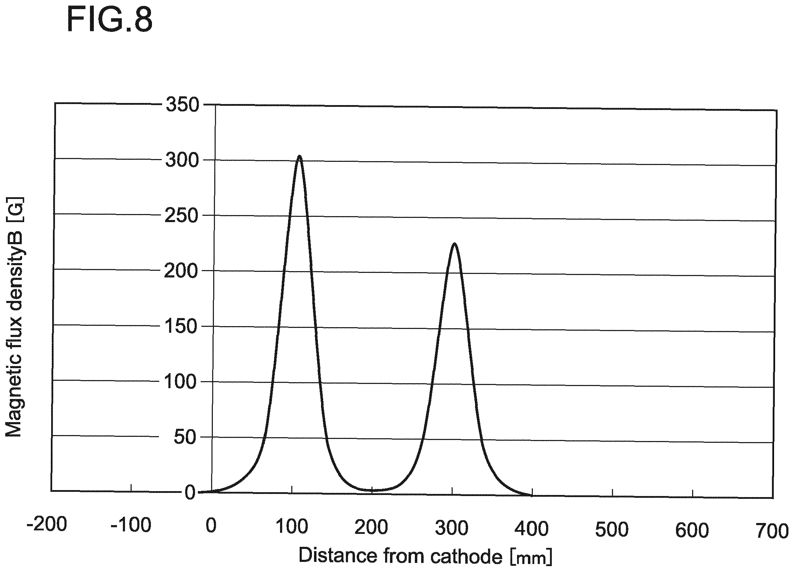

As described above, in the vapor deposition apparatus 1, the first focusing coil 28 of the electron gun 20 and the second focusing coil 52 and the third focusing coil 53 of the electron beam focusing mechanism 150 are provided at positions distant from the surface of the cathode 25 by 100 mm, 300 mm, and 500 mm, respectively. Fig. 8 shows a magnetic flux density distribution when a current of 2.5 A is caused to flow in the first focusing coil 28 and a current of 2.0 A is caused to flow in the second focusing coil 52. Further, in the case where a current of 2.0 A is caused to flow in the third focusing coil 53, a focusing magnetic field with a magnetic flux density distribution in which a peak of about 230 gausses appears at a position distant from the cathode by 500 mm can be further generated in the magnetic flux density distribution shown in Fig. 8.

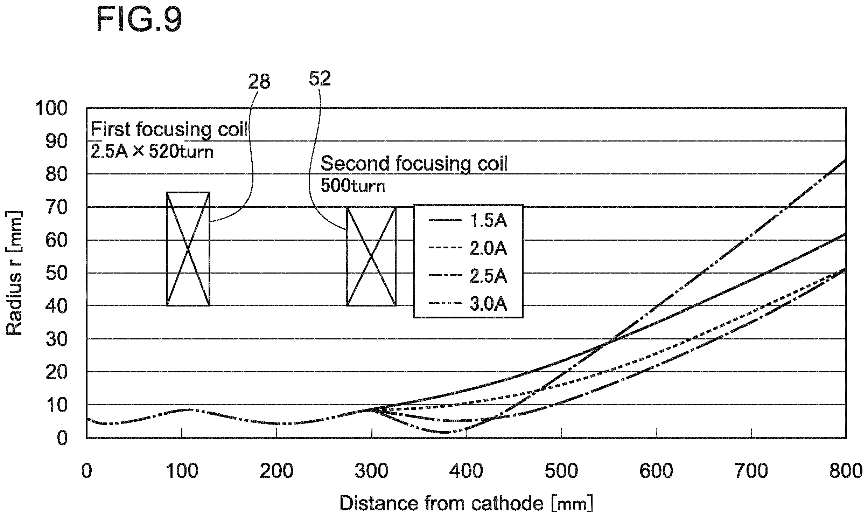

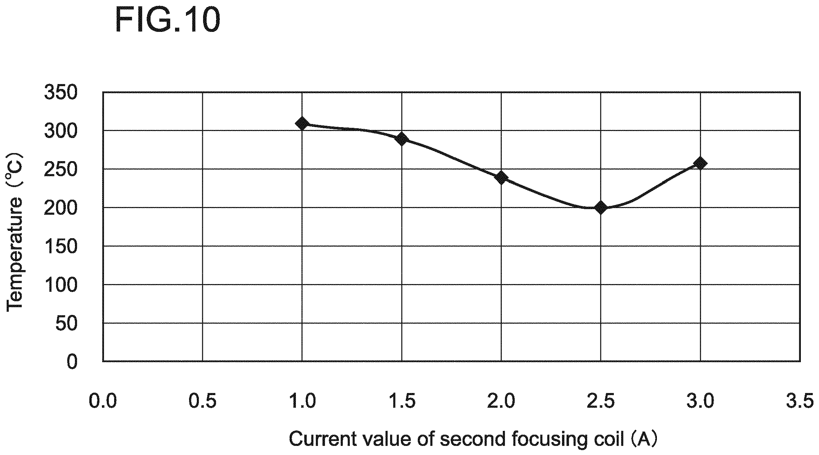

Fig. 9 shows simulation results of a state of the electron beam when, in the structure of the vapor deposition apparatus 1 described above, a pressure in the vacuum vapor deposition chamber 50 is set to 1.5×10⁻⁵ Pa, a current of 2.5 A is caused to flow in the first focusing coil 28, no current is caused to flow in the third focusing coil 53, and a value of a current caused to flow in the second focusing coil 52 is changed. Fig. 10 shows temperature measurement results by the thermocouple 57 arranged to correspond to the third focusing coil 53 under the same conditions. In Fig. 9, a radius r on the vertical axis is a radius r of a circular electron beam on a plane perpendicular to the traveling direction of the electron beam.

As shown in Fig. 10, when the current value caused to flow in the second focusing coil 52 is 2.5 A, the temperature indicates the smallest value.

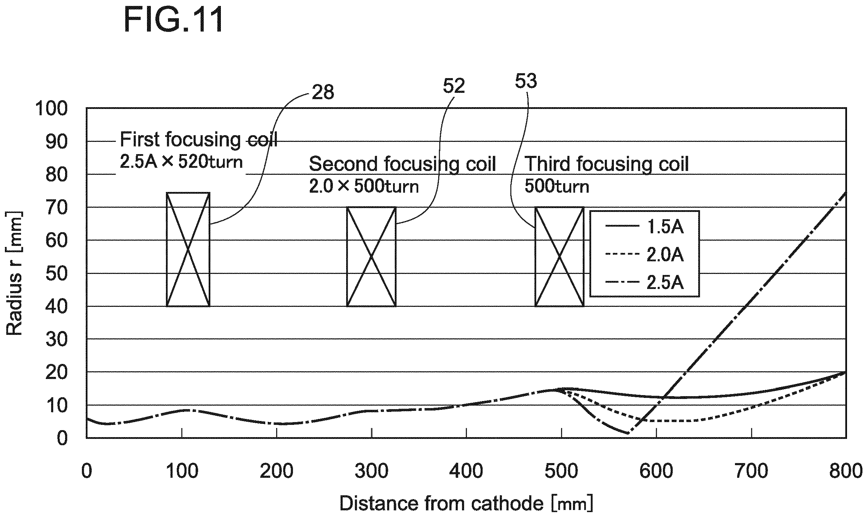

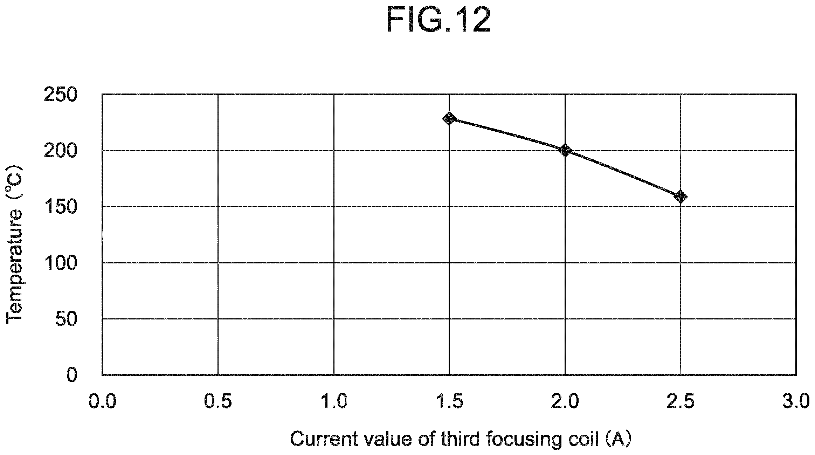

Fig. 11 shows simulation results of a state of the electron beam when, in the structure of the vapor deposition apparatus 1 described above, a pressure in the vacuum vapor deposition chamber 50 is set to 1.5×10⁻⁵ Pa, a current of 2.5 A is caused to flow in the first focusing coil 28, a current of 2.0 A is caused to flow in the second focusing coil 52, and a value of a current caused to flow in the third focusing coil 53 is changed. Fig. 12 shows temperature measurement results by the thermocouple 59 under the same conditions.

As shown in Fig. 11, in the case where the evaporation material 31 is arranged at a position distant from the cathode 25 of the electron gun 20 by 750 mm, a current value to be caused to flow in the third focusing coil 53 when the electron beam is most focused on the evaporation material 31 is 2.0 A.

Further, as shown in Figs. 10 and 12, it has been confirmed that the expanded state of the electron beam 40 can be grasped based on the temperature measured by the thermocouples. Specifically, when the diameter of the electron beam 40 is large, the temperature measured by the thermocouples is high. Further, since such an abnormal temperature that may damage the beam transport pipe 55 made of Cu can be detected by the temperature measurement by the thermocouples, the control can be performed such that the beam transport pipe made of Cu is prevented from being perforated.

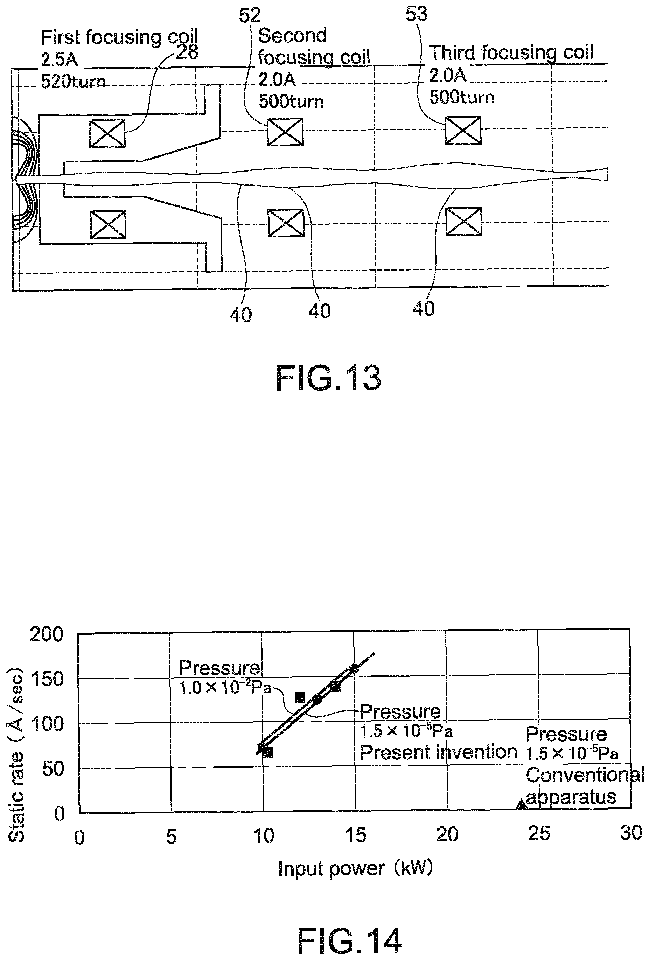

Based on the simulation results described above, the current caused to flow in the first focusing coil 28 is set to 2.5 A, the current caused to flow in the second focusing coil 52 is set to 2.0 A, and the current caused to flow in the third focusing coil 53 is set to 2.0 A. The state of the electron beam in this case is shown in Fig. 13.

As shown in Fig. 13, the focusing coils are arranged so as to correspond to portions where the electron beam 40 is diffused (r is increased), thus focusing the electron beam 40.

In the vapor deposition apparatus 1 described above, the first focusing coil 28, the second focusing coil 52, and the third focusing coil 53 were provided at positions distant from the cathode 25 by 100 mm, 300 mm, and 500 mm, respectively. A distance from the cathode 25 to the evaporation material 31 was set to 750 mm, and Mo was used as the evaporation material, to thereby form a Mo film. Fig. 14 shows a relationship between an input power and a static rate. The static rate was measured with CRTM (crystal oscillator) provided at 650 mm right above the evaporation material 31.

First, assuming a state where the electron beam focusing mechanism 150 is not provided like the conventional vapor deposition apparatus, a pressure of the vacuum vapor deposition chamber 50 was set to 1.0×10⁻² Pa without causing a current to flow in the second focusing coil 52 and the third focusing coil 53 of the electron beam focusing mechanism 150, to thereby form a film. Since the electron beam is focused by the neutralizing action of positive ions at a pressure of 1.0×10⁻² Pa, a static rate of 65.8 angstrom/sec was obtained at an input power of 10.3 kW and a static rate of 137.9 angstrom/sec was obtained at an input power of 14 kW.

Next, the pressure of the vacuum vapor deposition chamber 50 was set to 1.5×10⁻⁵ Pa, no current was caused to flow in the second focusing coil 52 and the third focusing coil 53 of the electron beam focusing mechanism 150, and the evaporation material 31 was irradiated with the electron beam 40. Since the neutralizing action by the positive ions is low, Mo hardly evaporated even when the power of 24 kW was input.

In this regard, the inside of the vacuum vapor deposition chamber 50 was set to a high vacuum atmosphere with a pressure of 1.5×10⁻⁵ Pa, a current of 2.0 A was caused to flow in the second focusing coil 52 of the electron beam focusing mechanism 150, and a current of 2.0 A was caused to flow in the third focusing coil 53, thus forming a film while monitoring the focused state of the electron beam by use of the thermocouples. As a result, a satisfactory deposition rate, that is, a static rate of 71 angstrom/sec at an input power of 10 kW and a static rate of 157.9 angstrom /sec at 15 kW were obtained. In other words, even in a high vacuum atmosphere, by providing the electron beam focusing mechanism 150 and focusing the electron beam by the mechanism 150, a deposition rate that is almost the same as a deposition rate obtained when the electron beam focusing mechanism 150 is not provided and the pressure in the vacuum vapor deposition chamber 50 is set to 1.0×10⁻² Pa could be achieved.

Further, it was visually confirmed that the diameter of the electron beam 40 on the evaporation material 31 is about 20 mm, and it was confirmed that the electron beam 40 is focused satisfactorily.

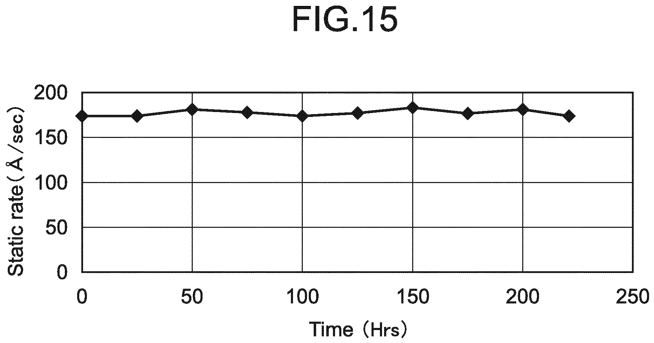

Further, the focused state of the electron beam was monitored using the thermocouples at the input power of 15 kW, and the deposition for 220 hours was performed while adjusting the current values of the second focusing coil 52 and the third focusing coil 53 such that the temperature measured by the thermocouples falls within a set range. As a result, as shown in Fig. 15, a stable deposition rate in a successive operation for a long period of time was obtained.

### [Modified examples]

Heretofore, the embodiment of the present invention has been described, but the present invention is not limited thereto as a matter of course and can be variously modified based on the technical idea of the present invention.

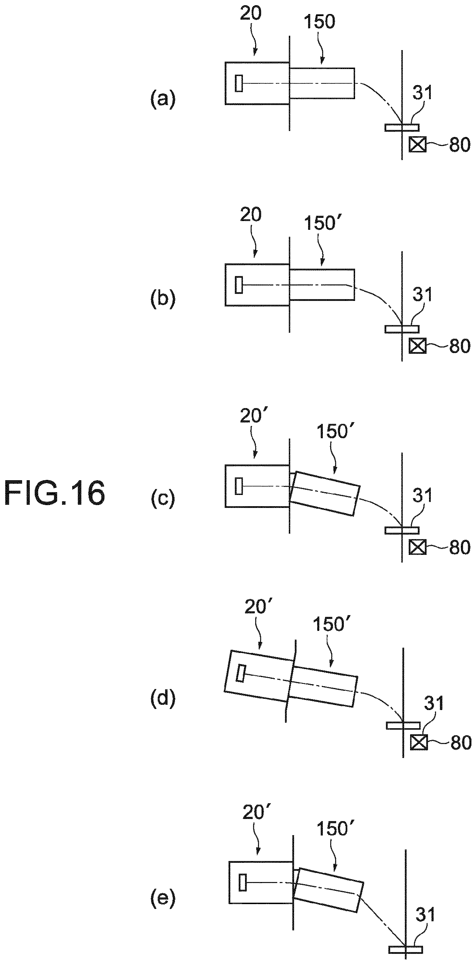

Figs. 16 are schematic cross-sectional diagrams showing a position relationship among the electron gun 20, the electron beam focusing mechanism 150, a deflection coil 80, and the evaporation material 31 in the vapor deposition apparatus of the present invention. Fig. 16(a) is a schematic cross-sectional diagram of the vapor deposition apparatus 1 in the embodiment shown in Fig. 1 and Fig. 2 described above, and Figs. 16(b) to 16(e) show Modified examples.

Although not illustrated in Fig. 1 and Fig. 2, as shown in Fig. 16(a), in the vapor deposition apparatus 1 of the embodiment described above, the deflection coil 80 is arranged in the vicinity of the evaporation material 31. The electron beam that has been output from the electron gun 20 and passed through the electron beam focusing mechanism 150 by the deflection coil 80 is deflected by the deflection coil 80 and then applied to the evaporation material 31. It should be noted that instead of the deflection coil 80, a permanent magnet can be used.

Fig. 16(b) shows Modified example 1. In Modified example 1, in addition to the deflection coil 80, the second oscillation coil 54 provided to an electron beam focusing mechanism 150' is also used to deflect the electron beam. Modified example 1 can be used in an atmosphere in which the neutralizing action by the positive ions is somewhat expected.

Fig. 16(c) shows Modified example 2. In Modified example 2, in addition to the structure of Modified example 1, the first oscillation coil 29 provided to an electron gun 20' was also used for deflection. Although a film attached to the inside of the electron beam focusing mechanism 150' is a problem, but the control on the shape of the electron beam becomes easy. Accordingly, Modified example 2 can be used for a process with a small evaporation amount or a process with a short successive operation time.

Fig. 16(d) shows Modified example 3. In the embodiment described above, the electron gun 20 (20') is arranged such that its longitudinal direction is horizontal. In contrast to this, in Modified example 3, the electron gun 20' and the electron beam focusing mechanism 150' are provided so as to be diagonally tilted toward the evaporation material 31. Since the shape of the electron beam is easily controlled, Modified example 3 can be used for a process with a small evaporation amount or a process with a short successive operation time.

Fig. 16(e) shows Modified example 4. In Modified example 4, the second oscillation coil 54 provided to the electron beam focusing mechanism 150' and the first oscillation coil 29 provided to the electron gun 20' are used for deflection, and the deflection coil 80 is not used. Since the deflection coil 80 is not used, the diameter of the electron beam is considerably focused, and the beam controllability in the evaporation material 31 is excellent. Further, Modified example 4 is applicable to a deposition process of an electromagnetic material.

Further, in the embodiment described above, the position where the second focusing coil 52 and the third focusing coil 53 are provided is set to have the distance as described above, but those conditions are merely examples and can be appropriately changed in accordance with an output of the electron beam, a desired beam diameter, a position where the evaporation material 31 is provided, and the like. In Fig. 1, the embodiment according to the present invention in which the in-line vapor deposition apparatus is used has been described. However, the present invention may be applied to a vapor deposition apparatus that forms a film while keeping the substrate still and a vapor deposition apparatus that forms a film while rotating the substrate. Further, the present invention may also be applied to not only the in-line vapor deposition apparatus, but also a load lock vapor deposition apparatus and a batch vapor deposition apparatus.

Furthermore, in the embodiment described above, the electron beam vapor deposition apparatus has been exemplified as the vacuum processing apparatus, but it is not limited thereto. The present invention may also be applied to various types of processing apparatuses using the electron beam, such as a surface treatment apparatus, a vacuum thermal processing apparatus, a vacuum melting furnace, and a vacuum refining furnace.

### Description of Numerals

- 1: vapor deposition apparatus
- 20: electron gun
- 50: vacuum vapor deposition chamber
- 28: first focusing coil
- 29: first oscillation coil
- 54: second oscillation coil
- 31: evaporation material
- 40: electron beam
- 52: second focusing coil
- 53: third focusing coil
- 56-59: thermocouple
- 61: control unit
- 150: electron beam focusing mechanism

## Claims

1. A vacuum processing apparatus, comprising:
a processing chamber (50) in which a target (10; 31) to be processed is set, the processing chamber (50) being capable of maintaining a vacuum atmosphere,
an electron gun (20) that is provided adjacently to the processing chamber (50) and emits an electron beam (40) to heat the target to be processed;
an electron beam focusing mechanism (150) that is provided in the processing chamber (50) and focuses the electron beam emitted from the electron gun (20), **characterised by** a first focusing coil (28) provided in the electron gun (20), a second focusing coil (52) provided in the electron beam focusing mechanism (150), and a third focusing coil (53) provided in the electron beam focusing mechanism (150), for focusing the electron beam,
wherein the electron beam focusing mechanism (150) includes
a thermocouple (56 - 59) that measures a temperature at a pass point of the electron beam,
a vacuum evacuation system that is provided between the first focusing coil (28) and the second focusing coil (52), and/or the second focusing coil (52) and the third focusing coil (53),
an inert gas supply mechanism for supplying an inert gas for the purpose of pressure adjustment, and
a control unit (61) that controls a pressure in the electron beam focusing mechanism (150), by using the vacuum evacuation system and the inert gas supply mechanism, based on a measurement result by the thermocouple (56 - 59).

2. The vacuum processing apparatus according to claim 1, wherein
the electron gun (20) is a pierce-type electron gun (20).

3. The vacuum processing apparatus according to claim 1, wherein
the electron gun (20) includes a first oscillation coil (29),
the electron beam focusing mechanism (150) includes a second oscillation coil (54), and
the electron beam is deflected by the first oscillation coil (29) and the second oscillation coil (54) and applied to the target to be processed.

4. The vacuum processing apparatus according to any one of claims 1 to 3, wherein
the target to be processed is an evaporation material (31), and
the electron gun (20) is a heat source to heat the evaporation material (31) by the electron beam.

5. The vacuum processing apparatus according to claim 4, wherein
the evaporation material (31) is metal or a metal oxide.

## Patentansprüche

1. Vakuumsverarbeitungsvorrichtung, aufweisend:
eine Verarbeitungskammer (50), in der ein Target (10; 31), das verarbeitet werden soll, eingesetzt ist, wobei die Verarbeitungskammer (50) in der Lage ist, eine Unterdruckatmosphäre aufrechtzuerhalten;
eine Elektronenkanone (20), die benachbart zu der Verarbeitungskammer (50) vorgesehen ist und einen Elektronenstrahl (40) emittiert, um das Target, das verarbeitet werden soll, zu erhitzen;
einen Fokussiermechanismus für den Elektronenstrahl (150), der in der Verarbeitungskammer (50) vorgesehen ist, und den Elektronenstrahl, der von der Elektronenkanone (20) emittiert wird, fokussiert,
**dadurch gekennzeichnet, dass**
eine erste Fokussierspule (28) in der Elektronenkanone (20) vorgesehen ist, eine zweite Fokussierspule (52) in dem Fokussiermechanismus für den Elektronenstrahl (150) vorgesehen ist, und eine dritte Fokussierspule (53) in dem Fokussiermechanismus für den Elektronenstrahl (150) vorgesehen ist, um den Elektronenstrahl zu fokussieren,
wobei der Elektronenstrahl-Fokussiermechanismus (150) umfasst,
ein Thermoelement (56-59), das eine Temperatur an einem Durchgangspunkt des Elektronenstrahls misst,
ein Vakuumevakuierungssystem, das zwischen der ersten Fokussierspule (28) und der zweiten Fokussierspule (52) bereitgestellt ist, und/oder der zweiten Fokussierspule (52) und der dritten Fokussierspule (53),
einen Schutzgas-Zuführmechanismus zum Zuführen eines Schutzgases zum Zwecke einer Druckanpassung, und
eine Steuereinheit (61), die einen Druck in dem Elektronenstrahl-Fokussiermechanismus (150) steuert, indem sie das Vakuumevakuierungssystem und den Schutzgas-Zuführmechanismus basierend auf einem Messergebnis von den Thermoelementen (56-59) nutzt.

2. Vakuumverarbeitungsvorrichtung gemäß Anspruch 1, wobei
die Elektronenkanone (20) eine Elektronenkanone der Durchstech-Art(20) ist.

3. Vakuumverarbeitungsvorrichtung nach Anspruch 1, wobei
die Elektronenkanone (20) eine erste Oszillationsspule (29) umfasst,
der Elektronenstrahl-Fokussiermechanismus (150) eine zweite Oszillationsspule (54) umfasst, und
der Elektronenstrahl durch die erste Oszillationsspule (29) und die zweite Oszillationsspule (54) abgelenkt und auf das zu verarbeitende Target aufgebracht wird.

4. Vakuumverarbeitungsvorrichtung nach einem der Ansprüche 1 bis 3, wobei
das zu verarbeitende Target ein Aufdampfmaterial (31) ist, und
die Elektronenkanone (20) eine Hitzequelle zum Erhitzen des Aufdampfmaterials (31) mittels des Elektronenstrahls ist.

5. Vakuumverarbeitungsvorrichtung nach Anspruch 4, wobei
das Aufdampfmaterial (31) Metall oder ein Metalloxid ist.

## Revendications

1. Appareil de traitement sous vide, comportant :
une chambre de traitement (50) dans laquelle est placée une cible (10; 31) destinée à être traitée, la chambre de traitement (50) étant capable de maintenir une atmosphère sous vide,
un canon à électrons (20) qui est disposé à proximité de la chambre de traitement (50) et qui émet un faisceau d'électrons (40) pour chauffer la cible devant être traitée ;
un mécanisme de focalisation (150) du faisceau d'électrons qui est monté dans la chambre de traitement (50) et focalise le faisceau d'électrons qui est émis par le canon à électrons (20), **caractérisé par**
une première bobine de focalisation (28) disposée dans le canon à électrons (20), une seconde bobine de focalisation (52) disposée dans le mécanisme de focalisation (150) du faisceau d'électrons, et une troisième bobine de focalisation (53) disposée dans le mécanisme de focalisation (150) du faisceau d'électrons, pour focaliser le faisceau d'électrons,
dans lequel le mécanisme de focalisation (150) du faisceau d'électrons comporte
un thermocouple (56 - 59) qui mesure une température à un point de passage du faisceau d'électrons,
un système d'évacuation du vide qui est disposé entre la première bobine de focalisation (28) et la seconde bobine de focalisation (52), et/ou la seconde bobine de focalisation (52) et la troisième bobine de focalisation (53),
un mécanisme d'alimentation en gaz inerte pour fournir un gaz inerte en vue d'assurer l'ajustement en pression, et
un unité de commande (61) qui commande une pression dans le mécanisme de focalisation (150) du faisceau d'électrons, en utilisant le système d'évacuation du vide et le mécanisme d'alimentation en gaz inerte, sur la base du résultat de mesure du thermocouple (56 - 59).

2. Appareil de traitement sous vide, selon la revendication 1, dans lequel le canon à électrons (20) est un canon à électrons (20) de type Pierce.

3. Appareil de traitement sous vide, selon la revendication 1, dans lequel
le canon à électrons (20) comporte une première bobine d'oscillation (29),
le mécanisme de focalisation (150) du faisceau d'électrons, comporte une seconde bobine d'oscillation (54), et
le faisceau d'électrons est dévié par la première bobine d'oscillation (29) et la seconde bobine d'oscillation (54) et appliqué à la cible devant être traitée.

4. Appareil de traitement sous vide, selon l'une quelconque des revendications 1 à 3, dans lequel
la cible devant être traitée est un matériau d'évaporation (31), et
le canon à électrons (20) est une source de chaleur pour chauffer le matériau d'évaporation (31), par le faisceau d'électrons.

5. Appareil de traitement sous vide, selon la revendication 4, dans lequel le matériau d'évaporation (31), est un métal ou un oxyde métallique.
